# FASCICULE DE BREVET EUROPEEN

(11) **EP 1 248 375 B1**
(45) Date de publication et mention de la délivrance du brevet: **24.05.2006**
(21) Numéro de dépôt: 01107741.9
(22) Date de dépôt: 02.04.2001
(51) Int. Cl.: H03M 3/02

(54) **Procédé de conversion analogique/numérique d'un signal analogique au sein d'un terminal d'un système de communication sans fil, par exemple un téléphone mobile, et terminal correspondant.**
Verfahren zur Analog-Digital-Wandlung eines Analogsignals in einem Endgerät eines drahtlosen Kommunikationssystems, z.B. einem Mobiltelefon, und zugehöriges Endgerät
Method for the analogue-to-digital conversion of an analogue signal in a terminal of a wireless communication system, e.g. a mobile telephone, and corresponding terminal

(43) Date de publication de la demande: 09.10.2002
(73) Titulaire: STMicroelectronics N.V., 1077 XX Amsterdam (NL)
(72) Inventeur: Arnaud, Thierry, 74330 Poisy (FR); Berens, Friedbert, 1202 Genève (CH)
(74) Mandataire: Dossmann, Gérard

(56) Documents cités:
- WO-A-01/03312
- US-A- 6 160 859
- RAMESH M C ET AL: "SIGMA DELTA ANALOG TO DIGITAL CONVERTERS WITH ADAPTIVE QUANTIZATION" PROCEEDINGS OF THE 40TH MIDWEST SYMPOSIUM ON CIRCUITS AND SYSTEMS. MWSCAS '97. SACRAMENTO, CA, AUG. 3 - 6, 1997, MIDWEST SYMPOSIUM ON CIRCUITS AND SYSTEMS, NEW-YORK, NY: IEEE, US, vol. 1, 3 août 1997 (1997-08-03), pages 22-30, XP000787715 ISBN: 0-7803-3695-X
- PATENT ABSTRACTS OF JAPAN vol. 018, no. 161 (E-1526) 17 Mars 1994 & JP 05 335 982 A (ICOM INC) 17 Décembre 1993

## Description

L'invention concerne d'une façon générale les systèmes de communication sans fil, et plus particulièrement les systèmes UMTS dans lesquelles plusieurs normes de transmission ont à être prises en compte par un terminal (GSM, GPRS, WCDMA (Systèmes à accès multiples par division de code large bande « Wide Band Code Division Multiple Access » en langue anglaise)...).

Dans un système de communication sans fil, une station de base communique avec une pluralité de terminaux distants, tels que des téléphones mobiles cellulaires. Les accès multiples par division de fréquence (FDMA : « Frequency-Division Multiple Access » en langue anglaise) et les accès multiples par division temporelle (TDMA : « Time Division Multiple Access » en langue anglaise) sont les schémas d'accès multiples traditionnels pour délivrer des services simultanés à un certain nombre de terminaux. L'idée de base sous-jacente aux systèmes FDMA et TDMA consiste à partager la ressource disponible, respectivement en plusieurs fréquences ou en plusieurs intervalles temporels, de telle sorte que plusieurs terminaux peuvent fonctionner simultanément sans provoquer d'interférence.

A l'opposé de ces schémas utilisant une division de fréquence ou une division temporelle, les schémas CDMA permettent aux utilisateurs multiples de partager une fréquence commune et un tel canal temporel commun en utilisant une modulation codée.

Plus précisément, comme il est bien connu par l'homme du métier, un code d'embrouillage (« scrambling code » en langue anglaise) est associé à chaque station de base et permet de distinguer une station de base d'une autre. En outre, un code orthogonal, connu par l'homme du métier sous la dénomination de « Code OVSF », est alloué à chaque terminal distant (comme par exemple un téléphone mobile cellulaire). Tous les codes OVSF sont orthogonaux entre eux, ce qui permet de distinguer un terminal distant d'un autre.

Avant d'émettre un signal sur le canal de transmission à destination d'un terminal distant, le signal a été embrouillé et étalé (« spreaded » en langue anglaise) par la section de base en utilisant le code d'embrouillage de la station de base et le code OVSF du terminal distant.

Dans les systèmes CDMA, on peut encore distinguer ceux qui utilisant une fréquence distincte pour l'émission et la réception (système CDMA-FDD) et ceux qui utilisent une fréquence commune pour l'émission et la réception, mais des domaines temporels distincts pour l'émission et la réception (système CDMA-TDD).

Les terminaux, tels que les téléphones mobiles cellulaires, de troisième génération doivent être compatibles avec la norme UMTS, c'est-à-dire qu'ils doivent être capables de fonctionner sous différentes normes de transmissions sans fil. Ainsi, ils devront être capables de fonctionner dans un système du type FDMA/TDMA, selon par exemple la norme de transmission GSM ou GPRS, ou encore dans des systèmes de communication du type CSMA-FDD ou CSMA-TDD, en utilisant par exemple les normes de transmission UTRA-FDD ou UTRA-TDD ou IS-95.

Le document WO 01/033/2 divulgue un récepteur équipé d'un convertisseur de type delta-sigma dont on peut faire varier les coefficients pour l'adapter à une norme particulière de transmission.

Il est donc extrêmement important de réduire au maximum le nombre de composants électroniques dans ces terminaux, afin d'en réduire la complexité d'intégration et la consommation de puissance pour obtenir une plus grande autonomie.

L'invention contribue à atteindre ces objectifs en agissant au niveau de l'étage de conversion analogique/numérique de ces terminaux.

L'invention propose donc un procédé de conversion analogique/numérique d'un signal analogique délivré par un étage de réception d'un terminal d'un système de communication sans fil, par exemple un téléphone cellulaire. Selon une caractéristique générale de l'invention, on effectue la conversion dans un convertisseur paramétrable type delta-sigma et on ajuste au vol les paramètres du convertisseur en fonction de la norme de transmission, du taux réel de transmission des données utiles et des conditions réelles de réception.

L'invention propose donc d'utiliser un seul convertisseur qui soit adaptable et flexible. Ce convertisseur unique est un convertisseur paramétrable de type delta-sigma. Aussi, puisqu'un seul convertisseur analogique/numérique est nécessaire pour supporter toute une gamme de systèmes de communication sans fil, par exemple les systèmes CDMA ou TDMA ou FDMA, la complexité de réalisation du terminal est réduite de façon très sensible. En outre, l'utilisation d'un convertisseur de type delta-sigma permet également de modifier la résolution du convertisseur en fonction du taux réel de transmission des données utiles c'est-à-dire les services transmis (par exemple transmission de données ou parole ou encore recherche de cellule dans une norme de transmission UTRA). La modification de la résolution du convertisseur peut également être adaptée en fonction des conditions réelles de réception, c'est-à-dire par exemple, des conditions d'environnement (niveau de réception, type d'environnement, etc...).

Ainsi, il pourra être possible dans certains cas de réduire d'un ou deux bits la résolution du convertisseur, et ce tout en satisfaisant des conditions acceptables de réception compte tenu du service demandé. Or, il a été observé qu'une diminution d'un bit de résolution pouvait conduire à une réduction de l'ordre de 30 à 40% de la consommation de courant.

Un convertisseur delta-sigma comprend un modulateur delta-sigma paramétrable, ce modulateur comportant un échantillonneur, ainsi qu'un filtre numérique de sortie paramétrable connecté en sortie du modulateur. Selon un mode de mise en oeuvre de l'invention, on ajuste alors les paramètres du modulateur en fonction de la norme de transmission souhaitée et on ajuste les coefficients du filtre de sortie et la valeur de la fréquence de suréchantillonnage de l'échantillonneur en fonction de la résolution souhaitée compte tenu du taux réel de transmission des données utiles et des conditions réelles de réception.

Le modulateur delta-sigma comporte également généralement une boucle affectée de coefficients de boucle, cette boucle comportant l'échantillonneur et au moins un intégrateur. L'ajustement des paramètres du modulateur peut alors comporter un ajustement des coefficients de boucle et de la valeur de la fréquence de suréchantillonnage.

La sélection entre les différentes résolutions et les différentes bandes passantes du signal (correspondant aux différentes normes de transmission), peuvent être commandées par le logiciel implémenté dans l'étage de traitement numérique qui suit le convertisseur analogique/numérique. A titre indicatif, en mesurant le « taux d'erreur bloc » (« BLock Error Rate » en langue anglaise) qui est une mesure représentative du taux d'erreur binaire du signal (« binary error rate » en langue anglaise) on peut obtenir une bonne estimation des conditions d'environnement. Et, la modification de la résolution et le contrôle des nouvelles valeurs de résolution peuvent être basés sur ces mesures.

Plus précisément, selon un mode de mise en oeuvre de l'invention, on effectue une mesure représentative du taux d'erreur binaire du signal. On compare cette valeur mesurée à une valeur de référence (qui dépend par exemple du service transmis, (paroles, transmission de données faible débit, etc...)). Et si, la valeur mesurée est inférieure à la valeur de référence, cela signifie que l'on peut avoir une certaine marge de manoeuvre pour diminuer la résolution du convertisseur. On ajuste alors les paramètres du convertisseur de façon à diminuer la résolution du convertisseur par paliers successifs. Et, à chaque palier on contrôle la résolution par une nouvelle mesure représentative du taux d'erreur binaire. Ainsi, à titre d'exemple, si l'on est en présence d'un taux réel de transmission de données utiles correspondant à un service de transmission de données de haute qualité (« high quality data service » en langue anglaise) la valeur de référence du taux d'erreur binaire est alors spécifiée à 10⁻⁶. Et, si le convertisseur est réglé pour une résolution de 8 bits et que l'on mesure un taux d'erreur binaire égal à 10⁻⁸ par exemple, on peut réduire la résolution tout d'abord à 7 bits. Si le nouveau taux d'erreur binaire est toujours inférieur à 10⁻⁶, on peut alors essayer de réduire la résolution à 6 bits. Et on procède ainsi de suite, généralement pas en deça de 4 bits pour un tel service, jusqu'à obtenir un taux d'erreur binaire mesuré compatible avec le taux d'erreur de référence requis pour ce service.

L'invention a également pour objet un terminal d'un système de communication sans fil, par exemple un téléphone mobile cellulaire, comprenant un étage de réception apte à recevoir un signal transmis et à délivrer un signal analogique, un convertisseur analogique/numérique pour convertir le signal analogique et un étage de traitement du signal numérique délivré par le convertisseur.

Selon une caractéristique générale de l'invention, le convertisseur est un convertisseur delta-sigma paramétrable et l'étage de traitement comporte des moyens de réglage aptes à ajuster au vol les paramètres du convertisseur en fonction de la norme de transmission, du taux réel de transmission des données utiles et des conditions réelles de réception.

Selon un mode de réalisation de l'invention, le convertisseur delta-sigma comprend un modulateur delta-sigma paramétrable comportant un échantillonneur, ainsi qu'un filtre de sortie. Les moyens de réglage comportent des premiers moyens d'ajustement aptes à ajuster les paramètres du modulateur en fonction de la norme de transmission, et des deuxièmes moyens d'ajustement aptes à ajuster les coefficients du filtre de sortie et la valeur de la fréquence de suréchantillonnage de l'échantillonneur en fonction de la résolution souhaitée compte tenu du taux réel de transmission des données utiles et des conditions réelles de réception.

Selon un mode de réalisation de l'invention, le modulateur delta-sigma comporte une boucle affectée de coefficients de boucle et comportant l'échantillonneur et au moins un intégrateur. Les premiers moyens d'ajustement sont alors aptes à ajuster les coefficients de boucle et la valeur de la fréquence de suréchantillonnage.

Les premiers moyens d'ajustement peuvent également, éventuellement ajuster la valeur des capacités des intégrateurs.

Selon un mode de réalisation de l'invention, les deuxièmes moyens d'ajustement comportent :
- une mémoire contenant des valeurs de référence représentatives de différents taux d'erreurs binaires de référence associées à différentes caractéristiques de transmission,
- des moyens de mesure aptes à effectuer une mesure représentative du taux d'erreur binaire du signal,
- des moyens de comparaison aptes à comparer cette valeur mesurée à une valeur de référence, et
- des moyens de contrôle aptes, si la valeur mesurée est inférieure à ladite valeur de référence, à ajuster les paramètres du convertisseur de façon à diminuer la résolution du convertisseur par paliers successifs, et à contrôler à chaque palier la nouvelle résolution à partir d'une nouvelle valeur de mesure délivrée par les moyens de mesure.

D'autres avantages et caractéristiques de l'invention apparaîtront à l'examen de la description détaillée de modes de mise en oeuvre et de réalisation nullement limitatifs, et des dessins annexés sur lesquels :
- la figure 1 illustre de façon schématique la structure d'un téléphone mobile cellulaire selon l'invention,
- la figure 2 illustre toujours schématiquement plus particulièrement la partie réception d'un téléphone mobile cellulaire selon l'invention, et
- la figure 3 illustre toujours schématiquement mais plus particulièrement la structure interne d'un convertisseur analogique/numérique d'un téléphone selon l'invention, ainsi que des moyens de réglage des paramètres du convertisseur.

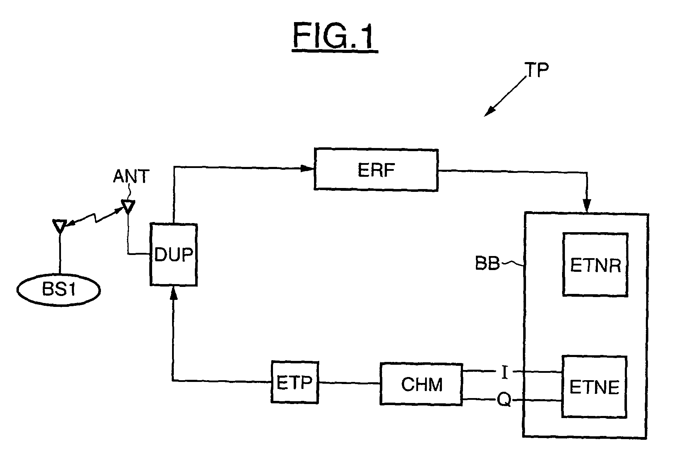

Sur la figure 1, la référence TP désigne un terminal distant, tel qu'un téléphone mobile cellulaire, qui est en communication avec une station de base BS1, par exemple selon un schéma de communication du type CDMA-FDD (par exemple norme UTRA-FDD).

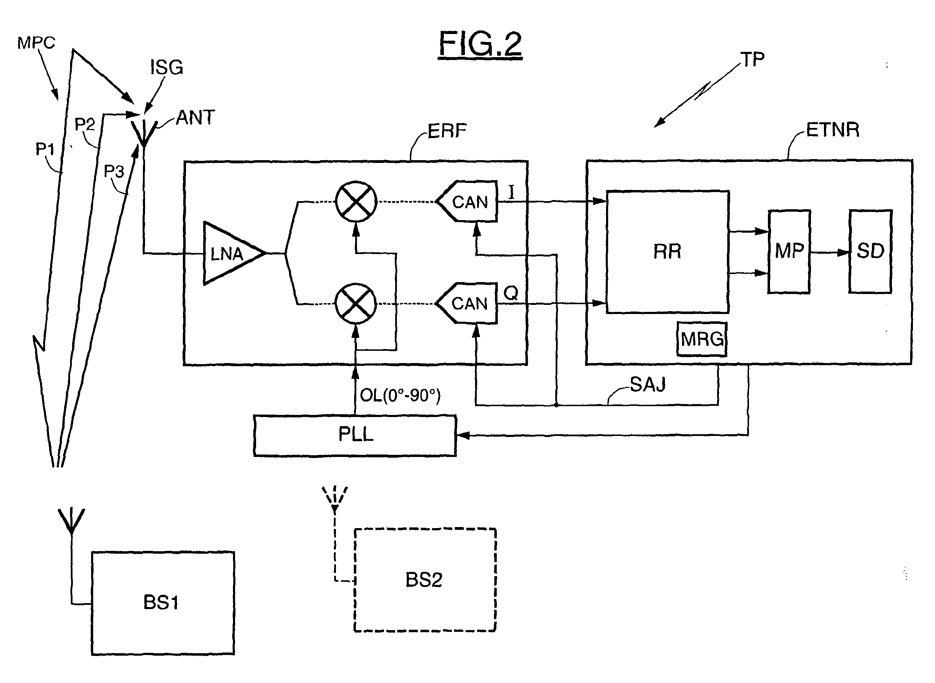

Le téléphone mobile cellulaire comprend, de façon classique, un étage analogique radiofréquence ERF connecté à une antenne ANT par l'intermédiaire d'un duplexeur DUP, pour recevoir un signal d'entrée ISG (figure 2).

Classiquement, l'étage ERF comprend (figure 2) un amplificateur faible bruit LNA et deux voies de traitement comportant des mélangeurs, des filtres et amplificateurs classiques (non représentés sur la figure 2 à des fins de simplification). Les deux mélangeurs reçoivent respectivement de la part d'une boucle à verrouillage de phase PLL deux signaux présentant mutuellement une différence de phase de 90°. Après transposition de fréquence dans les mélangeurs, les deux voies de traitement définissent respectivement deux flux I (flux direct) et Q (flux en quadrature) selon une dénomination bien connue de l'homme du métier.

Après conversion numérique dans des convertisseurs analogiques/numériques CAN, les deux flux I et Q sont délivrés à un étage de traitement de réception ETNR.

Cet étage de traitement ETNR comprend, de façon classique, un récepteur RR, communément désigné par l'homme du métier "récepteur Rake", suivi par des moyens classiques de démodulation MP qui effectuent la démodulation de la constellation délivrée par le récepteur Rake RR.

En raison des réflexions possibles du signal initialement, sur des obstacles se situant entre la station de base et le téléphone mobile, le milieu de transmission est en fait un milieu de transmission multi-trajets MPC, c'est-à-dire comprenant plusieurs chemins de transmission différents (trois chemins de transmission P1, P2, P3 sont représentés sur la figure 2). En conséquence, le signal ISG qui est reçu par le téléphone mobile comporte différentes versions temporellement retardées du signal initialement transmis, versions qui sont le résultat des caractéristiques de transmission multi-trajets du milieu de transmission. Et, chaque trajet introduit un retard différent.

Le récepteur Rake RR, qui équipe un téléphone mobile cellulaire fonctionnant dans un système de communication CDMA, est utilisé pour effectuer l'alignement temporel, le désembrouillage, le désétalement et la combinaison des versions retardées des signaux initiaux, de façon à délivrer les flux d'informations contenus dans les signaux initiaux. Bien entendu, le signal reçu ISG pourrait également résulter de la transmission de signaux initiaux respectivement émis par différentes stations de base BS1 et BS2.

L'étage de traitement ETNR comprend également de façon classique un décodeur de source SD qui effectue un décodage de source bien connu par l'homme du métier.

Comme il est également bien connu par l'homme du métier, la boucle à verrouillage de phase PLL est commandée par un algorithme de contrôle automatique de fréquence incorporé dans un processeur de l'étage ETNR.

Si l'on se réfère de nouveau plus particulièrement à la figure 1, on voit que le bloc de traitement en bande de base BB comporte, outre l'étage de traitement ETNR, un étage de traitement d'émission ETNE qui effectue, de façon classique, notamment les traitements de codage de source, d'étalement des symboles, de modulation, pour délivrer les deux flux I et Q à une chaîne d'émission CHM de structure classique.

Cette chaîne d'émission CHM comporte notamment en tête, des convertisseurs numériques / analogiques, ainsi que des mélangeurs permettant d'effectuer une transposition de fréquence à la fréquence d'émission. Là encore, les signaux de transposition sont délivrés par une boucle à verrouillage de phase (non représentée ici à des fins de simplification) contrôlée également par des moyens de contrôle automatique de fréquence incorporés dans l'étage ETNE.

La chaîne CHM est classiquement suivie d'un étage amplificateur de puissance ETP connecté à l'antenne par le duplexeur DUP.

Si l'on revient maintenant à l'étage ETNR, on voit que celui-ci comporte également maintenant des moyens de réglage MRG, incorporés de façon logiciels au sien du processeur de l'étage ETNR, et qui vont délivrer un signal d'ajustement SAJ aux convertisseurs CAN de façon à ajuster leurs paramètres en fonction de la norme de transmission utilisée, du service utilisé et des conditions environnementales de la réception.

On décrit maintenant plus en détails l'un des deux convertisseurs CAN, étant bien entendu que les deux convertisseurs sont identiques.

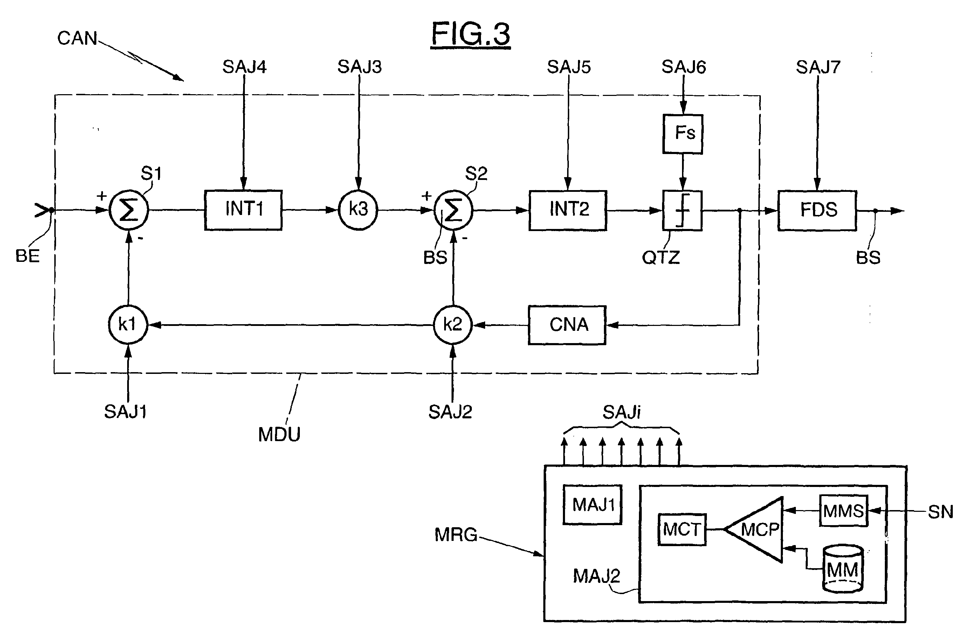

Le convertisseur CAN utilisé dans le terminal selon l'invention et illustré sur la figure 3 est un convertisseur du type delta-sigma. Sur la figure 3, le convertisseur delta-sigma CAN est d'ordre 2 (car il comporte deux intégrateurs). Ceci étant, l'invention s'applique à tout type de convertisseur delta-sigma quel que soit son ordre.

La structure d'un convertisseur analogique/numérique de type delta-sigma est classique est connu par l'homme du métier. On en rappelle ici brièvement les principales caractéristiques.

Le rôle du convertisseur analogique/numérique de type delta-sigma est d'échantillonner un signal analogique d'entrée en un signal numérique de sortie à une fréquence d'échantillonnage déterminée. Le convertisseur delta-sigma comporte notamment en tête un modulateur de type delta-sigma, référencé MDU, et en sortie, des filtres décimateurs de sortie FDS, par exemple des filtres à réponse impulsionnelle finie. La borne d'entrée BE du convertisseur CAN est également la borne d'entrée du modulateur delta-sigma MDU. Le modulateur MDU peut délivrer en sortie un signal échantillonné sur un voire 2 bits, la fréquence de suréchantillonnage Fs étant bien supérieure à la fréquence d'échantillonnage de sortie. Les échantillons successifs de 1 (ou 2 bits) sont délivrés au filtre décimateur FDS au rythme de la fréquence de suréchantillonnage.

Le modulateur MDU comporte en tête un premier sommateur S1 (soustracteur) relié à la borne d'entrée BE. Ce premier soustracteur est suivi d'un premier intégrateur INT1 dont la sortie est reliée à l'entrée d'un deuxième sommateur S2 (soustracteur) par l'intermédiaire d'un coefficient de boucle k3. La sortie du deuxième sommateur S2 est reliée à l'entrée d'un deuxième intégrateur INT2 qui est suivi d'un moyen de quantification QTZ (échantillonneur) dont la sortie constitue la sortie du modulateur MDU. La sortie du moyen de quantification QTZ est rebouclée sur les deux autres entrées des deux sommateurs S1 et S2 par l'intermédiaire d'un convertisseur numérique/analogique CNA et de deux autres coefficients de boucle k1 et k2. La modulation « DELTA » est basée sur la quantification de la modification du signal d'échantillon à échantillon, plutôt que sur la quantification de la valeur absolue du signal à chaque échantillon.

La présence d'un intégrateur (sigma) dans le modulateur confère au modulateur la dénomination de modulateur « delta-sigma ».

La sortie du modulateur delta-sigma est à une fréquence de suréchantillonnage Fs très élevée. C'est une caractéristique fondamentale des modulateurs delta-sigma parce qu'ils utilisent la portion haute fréquence du spectre pour repousser la majeure partie du bruit de quantification. En effet, un modulateur delta-sigma est conçu pour repousser le bruit de quantification hors de la bande du signal utile.

La réponse en fréquence du modulateur, c'est à dire la façon dont le bruit de quantification est repoussé en haute fréquence, peut être modifié en fonction de la norme de transmission en programmant les différents paramètres de boucle du modulateur (k1, k2, k3, INT1, INT2) ainsi que la fréquence Fs.

La conversion du signal de sortie suréchantillonné du modulateur delta-sigma sur un ou deux bits vers un signal à plus faible débit mais à nombre de bits plus élevé est ensuite réalisée dans les filtres décimateurs FDS dont la fonction consiste notamment à éliminer le bruit de quantification situé en dehors de la bande de signal utile pour ne laisser qu'une petite portion du bruit de quantification de la bande de signal utile (ce qui revient à augmenter la résolution effective de la sortie) puis à effectuer une décimation, c'est-à-dire une réduction de la fréquence de suréchantillonnage.

Une solution pour effectuer ces fonctions consiste à utiliser un filtre décimateur de type numérique. Une façon économique et simple consiste à utiliser un filtre décimateur en peigne, dont la structure est bien connue de l'homme du métier, ce filtre en peigne étant simplement un filtre à réponse impulsionnelle finie dont tous les coefficients sont égaux à 1 et qui se comporte comme un simple accumulateur effectuant une moyenne glissante. L'utilisation d'un filtre décimateur en peigne présente notamment l'avantage de ne requérir aucun multiplieur ni de nécessiter aucun stockage pour les coefficients du filtre. Ce filtre est ensuite suivi d'un filtre numérique éliminant les lobes de bruit résiduels du filtre en peigne.

A la borne de sortie BS du filtre, le signal numérique est formé d'échantillons (mots) dont la longueur définit la résolution du convertisseur. Cette résolution peut être par exemple de 13 bits pour une norme de transmission GSM ou DCS ou bien de 8 bits pour un service de transmission de données haute qualité dans une norme de transmission UTRA-FDD.

Une caractéristique essentielle de l'invention réside dans le fait que les paramètres du convertisseur analogique/numérique CAN peuvent être ajustés par les moyens de réglage MRG en fonction de la norme de transmission, du service requis (taux de transmission des données utiles) et des conditions réelles de transmission (environnement, interférences..).

A cet égard, on peut agir sur les paramètres du modulateur delta-sigma MDU, et/ou sur les coefficients du filtre de sortie FDS.

Plus précisément, comme on le voit schématiquement sur la figure 3, les coefficients de boucle k1, k2, k3, ainsi que la fréquence de suréchantillonnage Fs, et éventuellement les capacités des intégrateurs INT1 et INT2 peuvent être ajustés par l'intermédiaire de signaux d'ajustement SAJ1-SAJ6.

En agissant sur les signaux SAJ1-SAJ6, on peut adapter le convertisseur à la bande passante du signal, c'est-à-dire à la norme de transmission utilisée. Ainsi, le convertisseur selon l'invention peut être utilisé dans un téléphone UMTS capable de fonctionner selon les normes de transmission GSM, DCS ou UTRA. A titre indicatif, l'homme du métier sait que la bande passante du signal analogique en bande de base est de 200 Kilohertz pour la norme GSM et DCS et de 3,84 Mégahertz pour les systèmes WDCMA (norme de transmission UTRA).

L'homme du métier sait parfaitement déterminer les valeurs des coefficients k1, k2, k3, la valeur de la fréquence de suréchantillonnage Fs et éventuellement les valeurs des capacités des intégrateurs INT1 et INT2 pour adapter le convertisseur à une bande passante donnée du signal analogique. Ce calcul peut être effectué dans des premiers moyens d'ajustement MAJ1, par exemple de façon logiciel au sein d'un processeur, ou bien en utilisant des tables de correspondance pré mémorisées. L'ajustement des coefficients des filtres de sortie FDS et l'ajustement de la valeur de la fréquence de suréchantillonnage Fs permettent de modifier la valeur de la résolution du convertisseur. Là encore, l'homme du métier sait paramétrer les coefficients du filtre et la valeur de la fréquence de suréchantillonnage Fs pour obtenir une résolution souhaitée.

Cet aspect de l'invention permet ainsi d'adapter la résolution du convertisseur notamment au type de service demandé. Ainsi, dans une norme de transmission UTRA, la résolution requise durant une recherche de cellules peut être réduite à 1 ou 2 bits. Elle peut être également réduite à 2 bits dans un mode de réception dit « discontinu », bien connu de l'homme du métier sous le sigle DRX.

Par ailleurs, dans un système WCDMA, la résolution requise peut être différente selon le service proposé. A titre indicatif, la résolution peut être de 6 bits pour une transmission de parole, et de 8 bits pour une transmission de données haute qualité.

Ceci étant, au sein d'un même service, la résolution peut être éventuellement diminuée si les conditions de réception conduisent à un taux d'erreur binaire mesuré inférieur à un taux d'erreur binaire de référence requis pour ce service.

Ainsi, comme illustré sur la figure 3, les deuxièmes moyens d'ajustement MAJ2 comportent des moyens de mesures MMS capables de mesurer le taux d'erreur bloc (BLER) du signal numérique SN (qui est représentatif du taux d'erreur binaire BER du signal) et de le comparer à une valeur de référence stockée dans une mémoire MM. La sortie des moyens de comparaison MCP est reliée à des moyens de contrôle MCT qui vont, si cette valeur mesurée du taux d'erreur bloc est inférieur à la valeur de référence, diminuer par palier de 1 bit la résolution jusqu'à s'approcher, tout en restant inférieur, à la valeur de référence.

Ainsi, il est possible, pour un même service de réduire la résolution si les conditions d'environnement par exemple le permettent, et de réduire ainsi la puissance consommée par le convertisseur et par conséquent par le téléphone.

A titre d'exemple, pour un service de parole, la résolution peut être comprise entre 1 et 6 bits tandis qu'elle pourra être généralement comprise entre 4 et 8 bits pour un service de transmission de données haute qualité.

La conversion analogique / numérique paramétrable selon l'invention peut être aussi réalisée dans la station de base.

## Revendications

1. Procédé de conversion analogique/numérique d'un signal analogique délivré par un étage de réception d'un terminal d'un système de communication sans fil et résultant d'un signal transmis, où on effectue la conversion dans un convertisseur paramétrable de type delta-sigma (CAN) en fonction de la norme de transmission, **caractérisé par le fait qu'**on ajuste au vol les paramètres du convertisseur en fonction du taux réel de transmission des données utiles et des conditions réelles de réception.

2. Procédé selon la revendication 1, **caractérisé par le fait que** le convertisseur delta-sigma (CAN) comprend un modulateur delta-sigma paramétrable (MDU) comportant un échantillonneur (QTZ), ainsi qu'un filtre numérique de sortie paramétrable (FDS), **par le fait qu'**on ajuste les paramètres du modulateur en fonction de la norme de transmission et **par le fait qu'**on ajuste les coefficients du filtre de sortie et la valeur de la fréquence de suréchantillonnage (Fs) de l'échantillonneur en fonction de la résolution souhaitée compte tenu du taux réel de transmission des données utiles et des conditions réelles de réception.

3. Procédé selon la revendication 2, **caractérisé par le fait que** le modulateur comporte une boucle affectée de coefficients de boucle (k1, k2, k3) et comportant l'échantillonneur (QTZ) et au moins un intégrateur (INT1, INT2), et **par le fait que** l'ajustement des paramètres du modulateur comporte un ajustement des coefficients de boucle et de la valeur de la fréquence de suréchantillonnage.

4. Procédé selon la revendication 2 ou 3, **caractérisé par le fait qu'**on effectue une mesure (BLER) représentative du taux d'erreur binaire du signal, on compare cette valeur mesurée à une valeur de référence, et si la valeur mesurée est inférieure à la valeur de référence on ajuste les paramètres du convertisseur de façon à diminuer la résolution du convertisseur par paliers successifs, et à chaque palier on contrôle la nouvelle résolution par une nouvelle mesure représentative du taux d'erreur binaire.

5. Terminal d'un système de communication sans fil, comprenant un étage de réception apte à recevoir un signal transmis et à délivrer un signal analogique, un convertisseur analogique/numérique (CAN) pour convertir le signal analogique et un étage de traitement (ETNR) du signal numérique délivré par le convertisseur, le convertisseur (CAN) étant un convertisseur delta-sigma paramétrable en fonction de la norme de transmission, **caractérisé par le fait que** l'étage de traitement comporte des moyens de réglage (MRG) aptes à ajuster au voiles paramètres du convertisseur en fonction du taux réel de transmission des données utiles et des conditions réelles de réception

6. Terminal selon la revendication 5, **caractérisé par le fait que** le convertisseur delta-sigma comprend un modulateur delta-sigma paramétrable (MDU) comportant un échantillonneur (QTZ), ainsi qu'un filtre de sortie (FDS), **par le fait que** les moyens de réglage comportent des premiers moyens d'ajustement (MAJ1) aptes à ajuster les paramètres du modulateur en fonction de la norme de transmission, et des deuxièmes moyens d'ajustement (MAJ2) aptes à ajuster les coefficients du filtre de sortie et la valeur de la fréquence de suréchantillonnage de l'échantillonneur en fonction de la résolution souhaitée compte tenu du taux réel de transmission des données utiles et des conditions réelles de réception.

7. Terminal selon la revendication 6, **caractérisé par le fait que** le modulateur delta-sigma comporte une boucle affectée de coefficients de boucle (k1, k2, k3) et comportant l'échantillonneur et au moins un intégrateur, et **par le fait que** les premiers moyens d'ajustement (MAJ1) sont aptes à ajuster les coefficients de boucle et la valeur de la fréquence de suréchantillonnage.

8. Terminal selon la revendication 6 ou 7, **caractérisé par le fait que** les deuxièmes moyens d'ajustement (MAJ2) comportent
une mémoire (MM) contenant des valeurs de référence représentatives de différents taux d'erreurs binaires de références associés à différentes caractéristiques de transmission,
des moyens de mesure (MMS) aptes à effectuer une mesure représentative du taux d'erreur binaire du signal;
des moyens de comparaison (CMP) aptes à comparer cette valeur mesurée à une valeur de référence, et
des moyens de contrôle (MCT) aptes, si la valeur mesurée est inférieure à la valeur de référence, à ajuster les paramètres du convertisseur de façon à diminuer la résolution du convertisseur par paliers successifs, et à contrôler à chaque palier la nouvelle résolution à partir d'une nouvelle valeur de mesure délivrée par les moyens de mesure.

9. Terminal selon l'une des revendications 5 à 8, **caractérisé par le fait qu'**il est un téléphone mobile cellulaire.

## Claims

1. Process for the analogue/digital conversion of an analogue signal delivered by a reception stage of a terminal of a wireless communication system and resulting from a transmitted signal, where the conversion is performed in a parametrizable converter of delta-sigma type (ADC) as a function of the transmission standard, **characterized in that** the parameters of the converter are adjusted on the fly as a function of the actual rate of transmission of the useful data and of the actual conditions of reception.

2. Process according to Claim 1, **characterized in that** the delta-sigma converter (ADC) comprises a parametrizable delta-sigma modulator (MDU) which includes a sampler (QTZ), as well as a parametrizable digital output filter (FDS), **in that** the parameters of the modulator are adjusted as a function of the transmission standard and **in that** the coefficients of the output filter and the value of the oversampling frequency (Fs) of the sampler are adjusted as a function of the desired resolution having regard to the actual rate of transmission of the useful data and the actual conditions of reception.

3. Process according to Claim 2, **characterized in that** the modulator includes a loop having loop coefficients (k1, k2, k3) and including the sampler (QTZ) and at least one integrator (INT1, INT2), and **in that** the adjustment of the parameters of the modulator includes an adjustment of the loop coefficients and of the value of the oversampling frequency.

4. Process according to Claim 2 or 3, **characterized in that** a measurement (BLER) representative of the binary error rate of the signal is performed, this measured value is compared with a reference value, and if the measured value is less than the reference value the parameters of the converter are adjusted in such a way as to decrease the resolution of the converter in successive notches, and at each notch the new resolution is checked via a new measurement representative of the binary error rate.

5. Terminal of a wireless communication system, comprising a reception stage able to receive a transmitted signal and to deliver an analogue signal, an analogue/digital converter (ADC) for converting the analogue signal and a processing stage (ETNR) for the digital signal delivered by the converter, the converter (ADC) being a parametrizable delta-sigma converter as a function of the transmission standard, **characterized in that** the processing stage comprises tuning means (MRG) able to adjust the parameters of the converter on the fly as a function of the actual rate of transmission of the useful data and of the actual conditions of reception.

6. Terminal according to Claim 5, **characterized in that** the delta-sigma converter comprises a parametrizable delta-sigma modulator (MDU) which includes a sampler (QTZ), as well as an output filter (FDS), **in that** the tuning means include first means of adjustment (MAJ1) able to adjust the parameters of the modulator as a function of the transmission standard, and second means of adjustment (MAJ2) able to adjust the coefficients of the output filter and the value of the oversampling frequency of the sampler as a function of the desired resolution having regard to the actual rate of transmission of the useful data and the actual conditions of reception.

7. Terminal according to Claim 6, **characterized in that** the delta-sigma modulator includes a loop having loop coefficients (k1, k2, k3) and including the sampler and at least one integrator, and **in that** the first means of adjustment (MAJ1) are able to adjust the loop coefficients and the value of the oversampling frequency.

8. Terminal according to Claim 6 or 7, **characterized in that** the second means of adjustment (MAJ2) include:
a memory (MM) containing reference values representative of various reference binary error rates associated with various transmission characteristics,
measurement means (MMS) able to perform a measurement representative of the binary error rate of the signal,
comparison means (CMP) able to compare this measured value with a reference value, and
checking means (MCT) able, if the measured value is less than the reference value, to adjust the parameters of the converter in such a way as to decrease the resolution of the converter in successive notches, and to check at each notch the new resolution on the basis of a new measurement value delivered by the measurement means.

9. Terminal according to one of Claims 5 to 8, **characterized in that** it is a cellular mobile telephone.

## Patentansprüche

1. Verfahren zur Analog/Digital-Wandlung eines von einer Empfangsstufe eines Endgeräts eines drahtlosen Kommunikationssystems ausgegebenen und aus einem gesendeten Signal hervorgehenden analogen Signals, wobei die Wandlung in einem parametrisierbaren Wandler des Delta-Sigma-Typs (CAN) in Abhängigkeit von der Übertragungsnorm durchgeführt wird, **dadurch gekennzeichnet, daß** die Parameter des Wandlers in Abhängigkeit von der tatsächlichen Übertragungsrate von Nutzdaten und den tatsächlichen Empfangsbedingungen im Flug angepaßt werden.

2. Verfahren nach Anspruch 1, **dadurch gekennzeichnet, daß** der Delta-Sigma-Wandler (CAN) einen parametrisierbaren Delta-Sigma-Modulator (MDU) mit einem Abtaster (QTZ), sowie ain parametrisierbares digitales Ausgangsfilter (FDS) aufweist,
**dadurch**, daß die Parameter des Modulators: in Abhängigkeit von der Übertragungsnorm angepaßt werden, und
**dadurch**, daß die Koeffizienten des Ausgangsfilters und der Wert der Überabtastfrequenz (Fs) des Abtasters in Abhängigkeit von der gewünschten Auflösung unter Berücksichtigung der tatsächlichen Übertragungsrate von Nutzdaten und der tatsächlichen Empfangsbedingungen angepaßt werden.

3. Verfahren nach Anspruch-2, **dadurch gekennzeichnet, daß** der Modulator eine mit Schleifenkoeffizienten (k1, k2, k3) versehene Schleife aufweist, die den Abtaster (QTZ) und mindestens einen Integrator (INT1, INT2) aufweist, und **dadurch**, daß die Anpassung der Parameter des Modulators eine Anpassung der Schleifenkoeffizienten und des Werts der Überabtastfrequenz aufweist.

4. Verfahren nach Anspruch 2 oder 3, **dadurch gekennzeichnet daß** eine repräsentative Messung (BLER) der binären Fehlerrate des Signals durchgeführt wird, dieser gemessene Wert mit einem Referenzwert verglichen wird und, wenn der gemessene Wert kleiner ist als der Referenzwert, die Parameter des Wandlers so angepaßt werden, um die Auflösung des Wandlers in aufeinanderfolgenden Schritten herabzusetzen, und bei jedem Schritt die neue Auflösung durch eine neue repräsentative Messung der binären Fehlerrate überprüft wird.

5. Endgerät eines drahtlosen Kommunikations systems mit: einer Empfangsstufe, die ein gesendetes Signal empfangen und ein analoges Signal ausgeben kann,
einem Analog/Digital-Wandler (CAN), um das analoge Signal zu wandeln, und
einer Verarbeitungsstufe (ETNR) zur Verarbeitung des von dem Wandler ausgegebenen digitalen Signals,
wobei der Wandler (CAN) ein in Abhängigkeit von der Übertragungsnorm parametrisierbarer Delta-Sigma-Mandler ist,
**dadurch gekennzeichnet, daß** die Verarbeitungsstufe Regeleinrichtungen (MRG) aufweist, die die Parameter des Wandlers in Abhängigkeit von der tatsächlichen Übertragungsrate von Nutzdaten und den tatsächlichen Empfangsbedingungen im Flug anpassen können.

6. Endgerät nach Anspruch 5, **dadurch gekennzeichnet, daß**
der Delta-Sigma-Wandler einen parametrisierbaren Delta-Sigma-Modulator (MDU) mit einem Abtaster (QTZ), sowie ein Ausgangsfilter (FDS) aufweist,
**dadurch**, daß die Regeleinrichtungen erste Anpassungseinrichtungen (MAJ1) aufweisen, die die Parameter des Modulators in Abhängigkeit von der Übertragungsnorm anpassen können, und zweite Anpassungseinrichtungen (MAJ2) aufweisen, die die Koeffizienten des Ausgangsfilters und den Wert der Überabtastfrequenz des Abtasters in Abhängigkeit von der gewünschten Auflösung unter Berücksichtigung der tatsächlichen Übertragungsrate von Nutzdaten und der tatsächlichen Empfangsbedingungen anpassen können.

7. Endgerät nach Anspruch 6, **dadurch gekennzeichnet, daß**
der Delta-Sigma-Modulator eine mit Schleifenkoeffizienten (k1, k2, k3) versehene Schleife aufweist, die den Abtaster und mindestens einen Integrator aufweist, und **dadurch**, daß
die ersten Anpassungseinrichtungen (MAJ1) die Schleifenkoeffizienten und den Wert der Überabtastfrequehz anpassen können.

8. Endgerät nach Anspruch 6 oder 7, **dadurch gekennzeichnet, daß** die zweiten Anpassungseinrichtungen (MAJ2) aufweisen:
- einen Speicher (MM), der repräsentative leferenzwerte für verschiedene binäre Referenzfehlerraten, die verschiedenen Übertragungsmerkmalen zugeordnet sind, enthält
- Meßeinrichtungen (MMS), die eine repräsentative Messung der binären Fehlerrate des Signals durchführen können,
- Vergleichseinrichtungen (CMP), die diesen gemessenen Wert mit einem Referenzwert vergleichen können, und
- Steuereinrichtungen (MCT), welche, wenn der gemessene Wert unterhalb des Referenzwerts ist, die Parameter des Wandlers so anpassen können, daß die Auflösung des Wandlers in aufeinanderfolgenden Schritten herabgesetzt wird, und welche bei jedem Schritt die neue Auflösung ausgehend von einem neuen Meßwert, der von dem Meßeinrichtungen ausgegeben wird steuern können.

9. Endgerät nach einem der Ansprüche 5 bis 8, **dadurch gekennzeichnet, daß** es ein zellulares Mobiltelefon ist.
